# EUROPEAN PATENT SPECIFICATION

(11) **EP 4 152 131 B1**
(45) Date of publication and mention of the grant of the patent: **25.11.2026**
(21) Application number: 22205333.2
(22) Date of filing: 23.09.2020
(51) Int. Cl.: G06F 3/041, G06F 3/044, H05K 3/28, H05K 3/40, H05K 1/11

(54) **METHOD OF MANUFACTURING A LAYERED DEVICE**
VERFAHREN ZUR HERSTELLUNG EINER SCHICHTVORRICHTUNG
PROCÉDÉ DE FABRICATION D'UN DISPOSITIF STRATIFIÉ

(30) Priority: 23.09.2019 FI 20195798
(43) Date of publication of application: 22.03.2023
(62) Document number(s) of the earlier application(s) in accordance with Art. 76 EPC: 20786308.5 / 4 034 976
(73) Proprietor: Canatu Finland Oy, 01720 Vantaa (FI)
(72) Inventor: Varjos, Ilkka, 02920 Espoo (FI)
(74) Representative: Papula Oy

(56) References cited:
- WO-A1-2015/125339
- WO-A1-2019/031072
- CN-A- 103 324 321
- KR-A- 20100 119 759
- US-A1- 2015 185 889
- US-A1- 2017 094 800
- US-A1- 2018 210 573

## Description

### TECHNICAL FIELD

The present application relates to the field of layered devices used in electronics. The application further relates to methods for producing layered devices.

### BACKGROUND

Pressure-treatment techniques are used in manufacture of layered devices to create sealed and thin electronic devices and possibly form them onto a surface. These techniques include thermoforming, vacuum forming, lamination and many others involving the use of heat and pressure. In pressure-treatment, parts of a device which are brittle or positioned in exposed areas may be prone to damage from the pressure applied to the structure from opposite sides.

Known prior art includes KR 2010 0119759 A disclosing a method of manufacturing of multilayer printed circuit boards; US 2015/0185889 A1 disclosing a touch panel with bonding layers and spacers, and method of manufacturing thereof; US 2018/0210573 A1 disclosing a multilayer input device with curved surface, and method of manufacturing thereof using lamination; WO 2019/031072 A1 disclosing a manufacturing method of a multilayer input device where the method also includes a lamination step; CN 103 324 321 A disclosing a multilayer touch sensing device and method of manufacture thereof including molding; WO 2015/125339 A1 disclosing a curved touch sensor and method of producing thereof.

### SUMMARY

The method according to the present invention is characterized by what is presented in claim 1.

The term "comprising" is used in this specification to mean including the feature(s) or act(s) followed thereafter, without excluding the presence of one or more additional features or acts.

It will further be understood that reference to "an" item refers to one or more of those items.

The expressions "film" and "layer" should be understood in this specification, unless otherwise stated, as referring to a structure having its lateral dimensions substantially larger than its thickness. In that sense, a film may be considered as being a "thin" structure.

In an aspect, a method for producing a layered electronic device is provided. The method comprises providing a first base film and a second base film positioned parallel to the first base film at a predetermined distance, applying a conductive pattern to a surface of the first base film facing the second base film, printing a spacer on the first base film and a portion of the conductive pattern, creating at least one loose end of the conductive pattern by die-cutting or laser cutting a portion of the conductive pattern that corresponds to the portion of the conductive pattern to which the spacer is printed, preparing a bonding layer by cutting it to a predetermined shape comprising an opening, placing the bonding layer between the first base film and the second base film to fill at least partially the space between the first base film and the second base film, and enclosing a portion of the conductive pattern, such that the opening in the bonding layer is aligned with the location of the spacer printed on the first base film and the portion of the conductive pattern, and treating the resulting layered structure at a predetermined pressure and temperature. The bonding layer may comprise an adhesive or a thermoplastic film which can melt at a predetermined temperature.

The bonding layer may be placed between the first and second base films by various means. In one embodiment, the bonding layer is printed in a pattern onto the first base film and the conductive pattern. The pattern of the printed bonding layer may include one or more openings, therefore in this embodiment the operations of preparing the bonding layer and placing it between the films can be done in one step.

The operations prior to treating the resulting layered structures can provide a layered device Treating the resulting layered structure finalizes the production of a layered device. According to embodiments, treating may include forming, thermoforming, laminating or other techniques of pressure-treatment. The benefits of the method include efficiency of production and an improved resulting layered structure which is protected during the final pressure-treatment step, among others.

In an embodiment, the conductive pattern is applied to a surface of the first base film facing the second base film by depositing a conductive material and etching the conductive material to create a pattern. In an embodiment, conductive pattern is also applied to a surface of the second base film. In an embodiment, the conductive pattern is formed in the conductive material after having deposited the conductive material on the first base film and/or on the second base film.

In an embodiment, depending on the material of the conductive pattern, various procedures existing in the art may be used for depositing the conductive material. For example, the conductive material may be deposited by sputtering in vacuum conditions, printing, electroplating, depositing from gas phase, in a force field, depositing from a solution using spray coating or spin drying, or by any other appropriate method.

For the patterning, various processes may be used. In one embodiment, a laser process, an etching process, direct printing, a mechanical process, a burning process, or any combination thereof, is used for the patterning. In one embodiment, the laser process is laser ablation. In one embodiment, the etching process is a photolithographic process. In an embodiment, the pattern is formed simultaneously or after the conductive material is deposited on the first and/or on the second base film.

According to an embodiment, the operations of applying a conductive pattern and printing a spacer are performed on the second base film prior to adding the bonding layer between the first base film and the second base film. The conductive pattern on the second base film may be facing the first film or applied on the opposite surface of the second base film. The operations of the method may also be carried out multiple times to create a laminated or multilayered device comprising spacers between base films to reinforce the exposed portions of the conductive pattern during pressure-treatment.

In an embodiment, the pressure-treatment of the resulting layered structure comprises thermoforming at a temperature between 130 - 200 C.

In an embodiment, the pressure-treatment of the resulting layered structure comprises laminating in a vacuum at a temperature between 50 - 300 C, or at a temperature between 150 - 300 C, or at a temperature between 170-190 C. According to further embodiments, the pressure-treatment may comprise a combination of techniques such as thermoforming, laminating and others.

Creating a loose or detachable end of the conductive pattern prior to treating can provide easier access to the exposed portion of the conductive pattern, for example for providing a connection point to electrodes if the conductive pattern comprises electrodes.

In an embodiment, the method further comprises cooling the device after pressure-treating. The cooling operation may be required for securing a shape e.g. after thermoforming or any other process.

It will be understood that the benefits and advantages described above may relate to one embodiment or may relate to several embodiments. The embodiments are not limited to those that solve any or all of the indicated problems or those that have any or all of the stated benefits and advantages.

Further definitions are provided below. The first and second base films may be a first and a second substrate. The words "first" and "second" are used interchangeably and are simply used for clarity, for example the first and second base films may each be a bottom or top film if the device is positioned horizontally, etc.

An opening in the bonding layer and the exposed portion of the conductive pattern may be needed in various electronic applications to provide access to the conductive pattern, and possibly connection point. The device produced according to the method may be subjected to thermoforming, vacuum forming, lamination or any other pressure-based, and possibly temperature-based manufacturing process. In these processes, if the pressure is applied evenly across the first and second base films, the exposed portion of the conductive pattern which is not covered by the bonding layer due to an opening may be exposed to damage, due to the force with which the first and second base films are pressed into each other, and due to brittleness of the conductive pattern. The operation of "printing a spacer on the first base film and a portion of the conductive pattern" provides a spacer filling at least part of the space created by the opening, thereby providing protection against damage and breaking of the conductive pattern during high-pressure treatment.

The printed spacer may include structures that may comprise pillars, spacer dots or any other structures suitable for preventing excessive pressure on the conductive pattern during further manufacture. The spacer structures may also comprise material selected from: ultraviolet cross-linking polymer inks, thermally cross-linkable polymer inks and thermosetting inks.

The expression "transparent" should be understood in this specification, unless otherwise stated, as referring to optical transparency of the base films or the parts and materials thereof in the relevant wavelength range at issue. Transparent material or structure refers to a material or structure allowing light, or generally electromagnetic radiation, at such relevant wavelength to propagate through such material or structure. The relevant wavelength range may depend on the application where the laminated transparent film is to be used. Furthermore, the transparency of the base films or the parts thereof primarily refers to the transparency in the thickness direction of the laminated film or the parts thereof so that in order to be "transparent", sufficient portion of light energy incident on the base film or a part thereof shall propagate through it in the thickness direction.

A conductive "HARM structure" refers to electrically conductive "nanostructures", i.e. structures with one or more characteristic dimensions in nanometer scale, i.e. less or equal than about 100 nanometers. "High aspect ratio" refers to dimensions of the conductive structures in two perpendicular directions being in significantly different magnitudes of order. For example, a nanostructure may have a length which is tens or hundreds of times higher than its thickness and/or width. In a HARM-structures network, a great number of said nanostructures are interconnected with each other to form a network of electrically interconnected molecules. As considered at a macroscopic scale, a HARMS network forms a solid, monolithic material in which the individual molecular structures are disoriented or non-oriented, i.e. are oriented substantially randomly, or oriented. Various types of HARMS networks can be produced in the form of thin transparent layers with reasonable resistivity.

### BRIEF DESCRIPTION OF THE DRAWINGS

The accompanying drawings, which are included to provide a further understanding of the layered device and the method for its production, illustrate embodiments and together with the description help to explain the principles of the above. In the drawings:
Fig. 1a schematically illustrates a sectional view of a layered device according to an example;
Fig. 1b is a schematic sectional view of the layered device with spacer removed, according to an example;
Fig. 1c is a schematic sectional view of the layered device with spacer structures, according to an example;
Fig. 1d is a schematic sectional view of the layered device with combined spacers, according to an example;
Fig. 2a schematically illustrates a top view of a device with peel-off spacer, according to one example;
Fig. 2b is a schematic top view of a device with spacer structures, according to an example;
Fig. 3 schematically shows a sectional view of a flexible layered device comprising a loose conductive structure, manufactured according to an embodiment; and
Fig. 4 is a block diagram of a part of a method according to an embodiment.

### DETAILED DESCRIPTION

Reference will now be made in detail to the described embodiments, examples and implementations which are illustrated in the accompanying drawings.

The description below discloses some embodiments in such detail that a person skilled in the art can utilize the disclosed layered device and method based on the disclosure. Not all steps of the embodiments are discussed in detail, as some of the steps can be obvious for the person skilled in the art based on this specification.

For reasons of simplicity, item numbers will be maintained in the following exemplary embodiments in the case of repeating components.

The present specification generally relates to layered electronic devices, such as touch switches, touch sensors, touch displays, heating elements, solar cells and others. In these devices, when pressure-treatment such as pressure-forming, thermoforming, lamination or any other technique is used in manufacture, it is often desired to provide electrical contact with the layered device by leaving a portion of its conductive element exposed. However, the exposed portions are prone to damage during pressure-treatment because of the force created during such process. The device according to examples of the present specification comprises an additional spacer element which prevents such damage and protects the exposed portion of the conductive element. The method according to an aspect provides a process for manufacturing a layered device using the spacers.

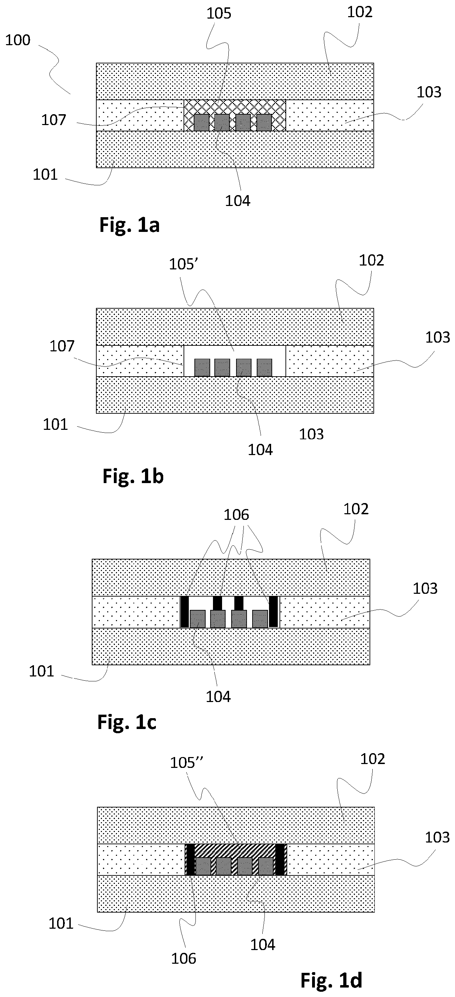

Fig. 1a illustrates schematically a sectional view of a layered device 100 according to an example implementation. The device comprises a first base film 101, a second base film 102 positioned parallel to the first one 101, a conductive pattern 104 attached to a surface of the first base film 101 facing the second base film 102, and a bonding layer 103 between them.

The first and second base films 101, 102 may be non-conductive substrates which insulate the conductive pattern 104. The base films 101, 102 can comprise a material selected from a group of: polyethylene terephthalate, polycarbonate, polymethyl methacrylate, cyclic olefin copolymer, triacetate, cyclic Olefin Copolymer, poly(vinyl chloride), poly(ethylene 2,6-naphthalate), polyimide, polypropylene, polyethylene, and any combination thereof.

The conductive pattern 104 is illustrated schematically as a set of conductive traces, according to an implementation. Conductive traces are commonly used in layered electronics such as touch sensors. However, the conductive pattern 104 may have any other suitable arrangement of conductive elements.

The conductive pattern 104 may comprise a network of conductive high aspect ratio molecular structures (HARM-structures) and be useful in transparent films due to the advantageous properties of some HARM-structures.

The bonding layer 103 fills at least partially the space between the first base film 101 and the second base film 102, enclosing a portion of the conductive pattern 104 and binding the first base film 101 and the second base film 102 together. The bonding layer 103 may comprise an adhesive. The bonding layer 103 may also comprise a bonding promoter selected from a group of: acrylic adhesive, silicon adhesive, polymer adhesive, a crosslinking polymer, epoxy adhesive, polycarbonate, a thermoplastic polyurethane (TPU) and any combination thereof. The adhesive may be an optically clear adhesives (OCR) which is useful in devices that require transparent films, for example devices with displays.

The bonding layer 103 comprises an opening 107, which may be at the side as shown with the side view of Fig. 1a, or inside the perimeter of the device 100. In an implementation, the opening 107 is arranged at the perimeter of the bonding layer 103 to provide an access point.

The conductive pattern 104 comprises at least one exposed portion aligned with the opening 107 in the bonding layer 103. The sectional view of Figs. 1a-1d is oriented so that the opening 107 and exposed portion of the conductive pattern 104 face the viewer.

This structure provides an access point for the conductive pattern 104, however if the device 100 is subjected to pressure-forming, thermoforming, laminating or other types of pressure-treatment, there is a potential for the exposed portion of the conductive pattern 104 to be damaged from the pressure. This is at least in part because of the opening 107 in the bonding layer 103 needed to provide the access. The opening 107 exposes a portion of the conductive pattern 104 and removes support which the bonding layer 103 provided elsewhere in the device 100.

The device 100 further comprises a spacer 105 attached to the first base film 101 and the exposed portion of the conductive pattern 104, wherein the spacer 105 fills at least part of the space created by the opening 107 in the bonding layer 103. Figs. 1a-1b illustrate an implementation wherein the spacer 105 comprises a peel-off coating 105 that evenly fills at least part of the space created by the opening 107 in the bonding layer 103. The peel-off coating 105 may comprise a polymer matrix, ultraviolet or thermally cross-linkable polymer, or a solvent-based or water-based solution.

The peel-off coating 105 can have a temporary use and be removed, for example peeled off or partially evaporated if it comprises solvent- or water-based solutions. It can be removed after the device manufacture is completed by pressure-treatment in a predetermined temperature. The pressure-treatment may comprise thermoforming at a temperature between 130 and 200 C, or laminating in a vacuum at a temperature between 170 and 190 C, or any other suitable pressure-based treatment which seals and/or forms layers of the device together and onto a surface. Fig. 1b shows the device 100 after thermoforming with the peel-off coating 105 removed, instead leaving a space 105' which can be filled later with a filler or remain empty.

Figs. 1c-1d illustrate an implementation wherein the spacer comprises two or more structures 106 rigidly fixed to the first base film 101 and the exposed portion of the conductive pattern 104. These structures 106 are positioned adjacent to each other at a predetermined distance.

In the implementation shown on Fig. 1c, the structures 106 are also aligned in height so that their upper surfaces lie substantially in the same plane as the lower surface of the second base film 102. The structures 106 shown in the example implementation of Fig. 1c are shaped as pillars, however any other suitable shape may be used for the spacer structures 106.

The rigidly fixed structures 106 can comprise material selected from: ultraviolet cross-linking polymer inks, thermally cross-linkable polymer inks and thermosetting inks. These materials can be rigid enough to withstand at least 5200 bars of pressure in temperatures up to 250 C, while protecting the conductive pattern 104 from damage during pressure-treatment.

Fig. 1d illustrates that the layered device 100 may comprise a combination of rigidly fixed pillars or spacer structures 106 and a peel-off additional coating 105". In some implementations, solid singular structures may be rigidly fixed to the first base film 101, if the protection these structures provide against pressure is sufficient.

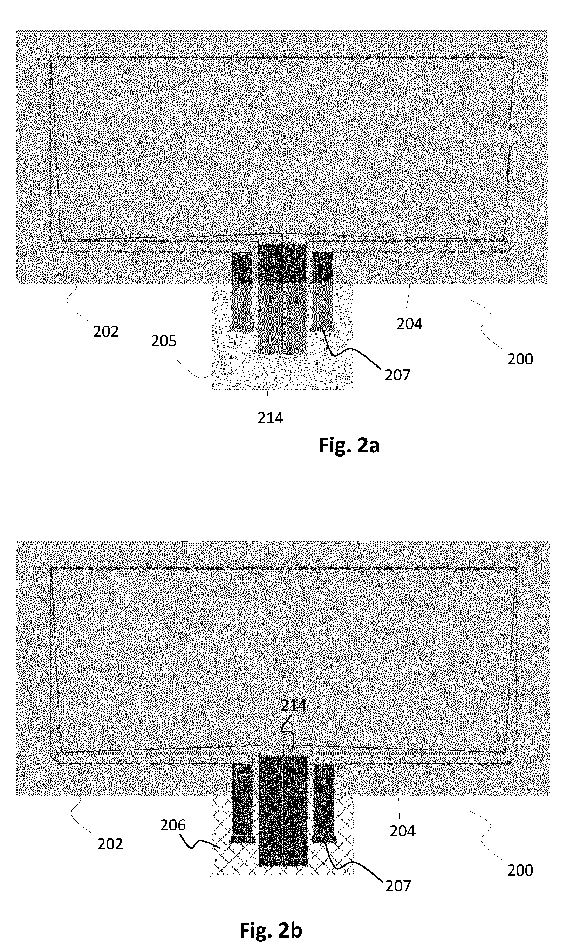

Fig. 2a is a schematic top view of a layered device 200 with a peel-off coating 206, and Fig. 2b is a schematic top view of a layered device 200 with rigidly fixed structures 206. The devices 200 shown in Figs. 2a-2b may be one example of the devices 100 shown in Figs. 1a-1d, accordingly. On Fig. 2b, the rigidly fixed structures are illustrated only schematically and may be positioned anywhere within the cross-dashed area 206.

In Figs. 2a-2b the conductive pattern 204 is shown to extend into the device, as it would for example in a touch sensor implementation. The conductive pattern 204 comprises an exposed portion with an exposed end portion 207. The end portion 207 or the whole exposed portion of the conductive pattern 204 can be made loose and detached from the first base film (not seen in Figs. 2a-2b). The second base film 202 is illustrated as the top film in the device 200. The first and/or the second 202 base films can be transparent.

In addition to the first conductive pattern 204 attached to the first base film, illustrated in Figs. 2a-2b as the outer part of the circuitry and the two pins positioned on the outside, device 200 can also comprise a second conductive pattern 214 (or any number thereof). The second conductive pattern 214 is attached to the second base film 202 at a surface facing the first base film. Although this is not visible in Figs. 2a-2b, the second conductive pattern 214 is attached to the inward facing surface of the second upper base film 202 according to this implementation. The first and second conductive patterns 204, 214 in this implementation are aligned to be separated in the plane of the parallel first and second 202 base films. This way the conductive patterns 204, 214 are arranged to avoid contact with each other during pressure treatment.

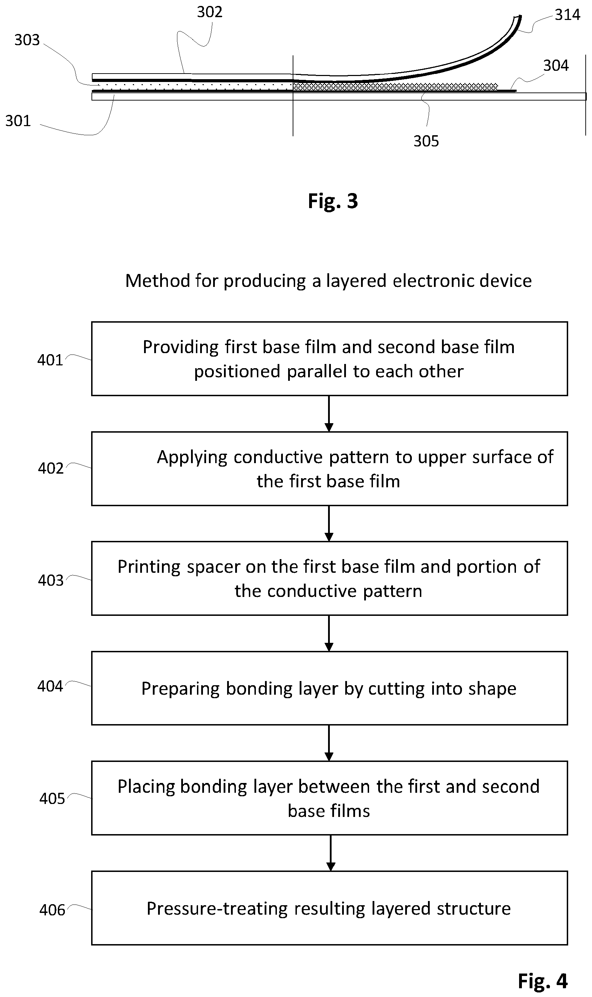

Fig. 3 is a schematic side view of a layered device manufactured according to an embodiment comprising two conductive patterns 304, 314 attached to the first base film 301 and the second base film 302, respectively. The device comprises a non-conductive bonding layer 303 insulating the conductive patterns 304, 314 and filling the space between the first and second base films 301, 302.

The device further comprises an opening in the adhesive layer 303 which is marked by the vertical lines on Fig. 3. The device also comprises a spacer 305 positioned between the conductive layers 304, 314 in place of the adhesive in the opening. The exposed portion of the conductive pattern 314 is made loose and detached from the first base film for easier external access (on the fight inFig. 3). InFig. 3at least the material of the second base film 302 allows it to be flexible.

Fig. 4 is a flow chart of a part of a method for producing a layered electronic device according to an embodiment. The method comprises providing 401 a first base film and a second base film positioned parallel to each other. The base films may be provided in a chamber or reactor for further assembly. The method further comprises applying 402 a conductive pattern to an upper surface of the first base film and printing 403 a spacer on the first base film and portion of the conductive pattern. The method then includes forming 404 a bonding layer filling the space between the first and second base films. Method also includes creating 405 an opening in bonding layer aligned with the spacer, for example by cutting it to a predetermined shape, such that the opening is aligned with the location of the spacer printed on the first base film and the portion of the conductive pattern.

Method is finished by pressure-treating 406 the resulting layered structure at a predetermined temperature. The pressure-treatment can be provided by any appropriate means and involves applying pressure to one of, or both the base films. In an implementation, the pressure-treatment also includes treating the resulting layered structure with UV crosslinking. In some examples, the pressure-treatment 406 of the resulting layered structure may comprise thermoforming at a temperature between 130 - 200 **C,** or any other suitable technique such as lamination and vacuum forming.

The operations prior to treating the resulting layered structures can provide a layered device as described in relation to any of the layered devices shown in Figs. 1a - 3. Treating the resulting layered structure finalizes the production of a layered device. According to some implementations, treating may include forming, thermoforming, laminating or other techniques of pressure-treatment. The benefits of the method include efficiency of production and an improved resulting layered structure which is protected during the final pressure-treatment step, among others.

The conductive pattern may be applied to a surface of the first base film facing the second base film by depositing a conductive material and etching the conductive material to create a pattern. A second conductive pattern can also be applied to a surface of the second base film.

The operations of applying 402 a conductive pattern and printing 403 a spacer can be performed on the second base film prior to forming 404 the bonding layer between the first base film and the second base film. The conductive pattern on the second base film may be facing the first film or applied on the opposite surface of the second base film. The operations of the method may also be carried out multiple times to create a laminated or multilayered device comprising spacers between base films to reinforce the exposed portions of the conductive pattern during pressure-treatment.

According to the invention, the method comprises creating at least one loose end of the conductive pattern by die-cutting or laser cutting a portion of the conductive pattern that corresponds to the portion of the conductive pattern to which the spacer is printed.

Creating a loose or detachable end of the conductive pattern prior to treating 406 can provide easier access to the exposed portion of the conductive pattern, for example for providing a connection point to electrodes if the conductive pattern comprises electrodes.

After pressure-treating 406, the method may also comprise cooling off the device (not shown on Fig. 4). The cooling operation may be required for securing a shape e.g. after thermoforming or any other process.

As it is clear to a person skilled in the art, the invention is not limited to the embodiments described above, but the embodiments can freely vary within the scope of the claims.

## Claims

1. A method for producing a layered electronic device, comprising
providing a first base film and a second base film positioned parallel to the first base film at a predetermined distance,
applying a conductive pattern to a surface of the first base film facing the second base film,
printing a spacer on the first base film and a portion of the conductive pattern,
creating at least one loose end of the conductive pattern by die-cutting or laser cutting a portion of the conductive pattern that corresponds to the portion of the conductive pattern to which the spacer is printed,
preparing a bonding layer by cutting it to a predetermined shape comprising an opening,
placing the bonding layer between the first base film and the second base film to fill at least partially the space between the first base film and the second base film, and enclosing a portion of the conductive pattern, such that the opening in the bonding layer is aligned with the location of the spacer printed on the first base film and the portion of the conductive pattern,
and pressure-treating the resulting layered structure at a predetermined temperature.

2. The method of claim 1, wherein the conductive pattern is applied to a surface of the first base film facing the second base film by depositing a conductive material and etching the conductive material to create a pattern.

3. The method of any one of claims 1 and 2, wherein the operation of applying a conductive pattern is also performed on the second base film prior to adding the adhesive between the first base film and the second base film.

4. The method of any one of claims 1-3, wherein the pressure-treatment of the resulting layered structure comprises thermoforming at a temperature between 130 and 200 C.

5. The method of any one of claims 1-3, wherein the pressure-treatment of the resulting layered structure comprises laminating in a vacuum at a temperature between 50 - 300 C, or at a temperature between 150 - 300 C, or at a temperature between 170-190 C.

6. The method of any one of claims 1-5, further comprising cooling the device after pressure-treating.

## Patentansprüche

1. Verfahren zur Herstellung einer elektronischen Schichtvorrichtung, umfassend:
Bereitstellen eines ersten Basisfilms und eines zweiten Basisfilms, der parallel zu dem ersten Basisfilm in einem vorbestimmten Abstand positioniert ist,
Aufbringen eines leitfähigen Musters auf einer Oberfläche des ersten Basisfilms, die dem zweiten Basisfilm zugewandt ist,
Drucken eines Spacers auf den ersten Basisfilm und einen Bereich des leitfähigen Musters,
Erzeugen wenigstens eines losen Endes des leitfähigen Musters durch Ausstanzen oder Laserschneiden eines Bereichs des leitfähigen Musters, der dem Bereich des leitfähigen Musters entspricht, auf den der Spacer gedruckt ist,
Vorbereiten einer Bondingschicht durch Schneiden derselben auf eine vorbestimmte Form, die eine Öffnung umfasst,
Platzieren der Bondingschicht zwischen dem ersten Basisfilm und dem zweiten Basisfilm, um wenigstens teilweise den Raum zwischen dem ersten Basisfilm und dem zweiten Basisfilm zu füllen, und Einschließen eines Bereichs des leitfähigen Musters derart, dass die Öffnung in der Bondingschicht mit dem Ort des Spacers ausgerichtet ist, der auf den ersten Basisfilm und den Bereich des leitfähigen Musters gedruckt ist,
und Druckbehandeln der resultierenden Schichtstruktur bei einer vorbestimmten Temperatur.

2. Verfahren nach Anspruch 1, wobei das leitfähige Muster auf eine Oberfläche des ersten Basisfilms, die dem zweiten Basisfilm zugewandt ist, durch Abscheiden eines leitfähigen Materials und Ätzen des leitfähigen Materials zum Erzeugen eines Musters aufgebracht wird.

3. Verfahren nach einem der Ansprüche 1 und 2, wobei der Arbeitsschritt des Aufbringens eines leitfähigen Musters auch an dem zweiten Basisfilm durchgeführt wird, bevor das Haftmittel zwischen dem ersten Basisfilm und dem zweiten Basisfilm hinzugefügt wird.

4. Verfahren nach einem der Ansprüche 1 bis 3, wobei die Druckbehandlung der resultierenden Schichtstruktur eine Thermoverformung bei einer Temperatur zwischen 130 und 200° C umfasst.

5. Verfahren nach einem der Ansprüche 1 bis 3, wobei die Druckbehandlung der resultierenden Schichtstruktur ein Laminieren in einem Vakuum bei einer Temperatur zwischen 50 bis 300° C umfasst, oder bei einer Temperatur zwischen 150 bis 300° C, oder bei einer Temperatur zwischen 170 bis 190° C.

6. Verfahren nach einem der Ansprüche 1 bis 5, ferner umfassend ein Kühlen der Vorrichtung nach der Druckbehandlung.

## Revendications

1. Procédé de fabrication d'un dispositif électronique stratifié, comprenant
la fourniture d'un premier film de base et d'un second film de base positionné parallèlement au premier film de base à une distance prédéterminée,
l'application d'un motif conducteur à une surface du premier film de base faisant face au second film de base,
l'impression d'une entretoise sur le premier film de base et d'une partie du motif conducteur,
la création d'au moins une extrémité libre du motif conducteur par découpage à l'emporte-pièce ou découpage laser d'une partie du motif conducteur qui correspond à la partie du motif conducteur sur laquelle l'entretoise est imprimée,
la préparation d'une couche de liaison par la découpe de celle-ci selon une forme prédéterminée comprenant une ouverture,
la mise en place de la couche de liaison entre le premier film de base et le second film de base pour remplir au moins partiellement l'espace entre le premier film de base et le second film de base, et l'inclusion d'une partie du motif conducteur, de sorte que l'ouverture dans la couche de liaison soit alignée avec l'emplacement de l'entretoise imprimée sur le premier film de base et la partie du motif conducteur, et
le traitement sous pression de la structure stratifiée résultante à un traitement par pression à une température prédéterminée.

2. Procédé selon la revendication 1, dans lequel le motif conducteur est appliqué à une surface du premier film de base faisant face au second film de base par le dépôt d'un matériau conducteur et la gravure du matériau conducteur pour créer un motif.

3. Procédé selon l'une quelconque des revendications 1 et 2, dans lequel l'opération d'application d'un motif conducteur est également effectuée sur le second film de base avant l'ajout de l'adhésif entre le premier film de base et le second film de base.

4. Procédé selon l'une quelconque des revendications 1 à 3, dans lequel le traitement par pression de la structure stratifiée résultante comprend un thermoformage à une température comprise entre 130 et 200 °C.

5. Procédé selon l'une quelconque des revendications 1 à 3, dans lequel le traitement par pression de la structure stratifiée résultante comprend un laminage sous vide à une température comprise entre 50 et 300 °C, ou à une température comprise entre 150 et 300 °C, ou à une température comprise entre 170 et 190 °C.

6. Procédé selon l'une quelconque des revendications 1 à 5, comprenant en outre le refroidissement du dispositif après le traitement par pression.
